# EUROPÄISCHE PATENTSCHRIFT

(11) **EP 2 385 556 B1**
(45) Veröffentlichungstag und Bekanntmachung des Hinweises auf die Patenterteilung: **20.01.2021**
(21) Anmeldenummer: 10161920.3
(22) Anmeldetag: 04.05.2010
(51) Int. Cl.: H01L 27/30, H01L 51/42

(54) **Photoaktives Bauelement mit organischen Schichten**
Photoactive device with organic layers
Composant photo-actif doté de couches organiques

(43) Veröffentlichungstag der Anmeldung: 09.11.2011
(73) Patentinhaber: Heliatek GmbH, 01139 Dresden (DE)
(72) Erfinder: Männig, Bert, 01139 Dresden (DE); Pfeiffer, Martin, 01139 Dresden (DE); Uhrich, Christian, 01139 Dresden (DE)

(56) Entgegenhaltungen:
- EP-A1- 2 037 528
- WO-A1-2007/024695
- WO-A1-2010/036963
- CASTRO F A ET AL: "On the use of cyanine dyes as low-bandgap materials in bulk heterojunction photovoltaic devices" SYNTHETIC METALS, ELSEVIER SEQUOIA, LAUSANNE, CH LNKD- DOI:10.1016/J.SYNTHMET.2006.06.010, Bd. 156, Nr. 14-15, 1. Juli 2006 (2006-07-01), Seiten 973-978, XP025086608 ISSN: 0379-6779 [gefunden am 2006-07-01]
- TOSHIHIRO YAMANARI ET AL: "Dye-Sensitized Bulk Heterojunction Polymer Solar Cells" PHOTOVOLTAIC ENERGY CONVERSION, CONFERENCE RECORD OF THE 2006 IEEE 4TH WORLD CONFERENCE ON, IEEE, PI, 1. Mai 2006 (2006-05-01), Seiten 240-243, XP031007283 ISBN: 978-1-4244-0016-4
- BRUDER I ET AL: "Efficient organic tandem cell combining a solid state dye-sensitized and a vacuum deposited bulk heterojunction solar cell" SOLAR ENERGY MATERIALS AND SOLAR CELLS, ELSEVIER SCIENCE PUBLISHERS, AMSTERDAM, NL, Bd. 93, Nr. 10, 1. Oktober 2009 (2009-10-01), Seiten 1896-1899, XP026459910 ISSN: 0927-0248 [gefunden am 2009-06-18]
- STOLZ ROMAN L ET AL: "TRAPPING LIGHT IN POLYMER PHOTODIODES WITH SOFT EMBOSSED GRATINGS" ADVANCED MATERIALS, WILEY VCH VERLAG, DE LNKD- DOI:10.1002/(SICI)1521-4095(200002)12:3&LT ,189::AID-ADMA189&GT,3.0.CO,2-, Bd. 12, Nr. 3, 3. Februar 2000 (2000-02-03), Seiten 189-195, XP000923550 ISSN: 0935-9648

## Beschreibung

Die Erfindung betrifft ein Photoaktives Bauelement mit organischen Schichten, bestehend aus einer Einfach-, Tandem- oder Mehrfachzelle mit zwei Elektroden und zwischen den Elektroden ein photoaktives Akzeptor-Donator-Schichtsystem mit zumindest drei Absorbermaterialien.

Seit der Demonstration der ersten organischen Solarzelle mit einem Wirkungsgrad im Prozentbereich durch Tang et al. 1986 [C.W. Tang et al. Appl. Phys. Lett. 48, 183 (1986)], werden organische Materialien intensiv für verschiedene elektronische und optoelektronische Bauelemente untersucht. Organische Solarzellen bestehen aus einer Folge dünner Schichten (typischerweise 1nm bis 1µm) aus organischen Materialien, welche bevorzugt im Vakuum aufgedampft oder aus einer Lösung aufgeschleudert werden. Die elektrische Kontaktierung kann durch Metallschichten, transparente leitfähige Oxide (TCOs) und/oder transparente leitfähige Polymere (PEDOT-PSS, PANI) erfolgen.

Eine Solarzelle wandelt Lichtenergie in elektrische Energie um. Der Begriff photoaktiv bezeichnet hierbei ebenfalls die Umwandlung von Lichtenergie in elektrische Energie. Im Gegensatz zu anorganische Solarzellen werden bei organischen Solarzellen durch das Licht nicht direkt freie Ladungsträger erzeugt, sondern es bilden sich zunächst Exzitonen, also elektrisch neutrale Anregungszustände (gebundene Elektron-Loch-Paare). Erst in einem zweiten Schritt werden diese Exzitonen in freie Ladungsträger getrennt, die dann zum elektrischen Stromfluß beitragen.

Der Vorteil solcher Bauelemente auf organischer Basis gegenüber den konventionellen Bauelementen auf anorganischer

Basis (Halbleiter wie Silizium, Galliumarsenid) sind die teilweise extrem hohen optischen Absorptionskoeffizienten (bis zu 2x105 cm⁻¹) , so dass sich die Möglichkeit bietet, mit geringem Material- und Energieaufwand sehr dünne Solarzellen herzustellen. Weitere technologische Aspekte sind die niedrigen Kosten, die Möglichkeit, flexible großflächige Bauteile auf Plastikfolien herzustellen, und die nahezu unbegrenzten Variationsmöglichkeiten und die unbegrenzte Verfügbarkeit der organischen Chemie.

Eine in der Literatur bereits vorgeschlagene Realisierungsmöglichkeit einer organischen Solarzelle besteht in einer pin -Diode [Martin Pfeiffer, "Controlled doping of organic vacuum deposited dye layers: basics and applications", PhD thesis TU-Dresden, 1999.] mit folgendem Schichtaufbau:
0. Träger, Substrat,
1. Grundkontakt, meist transparent,
2. p- Schicht(en),
3. i- Schicht(en),
4. n- Schicht(en),
5. Deckkontakt.

Hierbei bedeutet n bzw. p eine n- bzw. p-Dotierung, die zu einer Erhöhung der Dichte freier Elektronen bzw. Löcher im thermischen Gleichgewichtszustand führt. Es ist allerdings auch möglich, dass die n-Schicht(en) bzw. p-Schicht(en) zumindest teilweise nominell undotiert sind und nur aufgrund der Materialeigenschaften (z.B. unterschiedliche Beweglichkeiten), aufgrund unbekannter Verunreinigungen (z.B. verbliebene Reste aus der Synthese, Zerfalls- oder Reaktionsprodukte während der Schichtherstellung) oder aufgrund von Einflüssen der Umgebung (z.B. angrenzende Schichten, Eindiffusion von Metallen oder anderen organischen Materialien, Gasdotierung aus der Umgebungsatmosphäre) bevorzugt n-leitende bzw. bevorzugt p-leitende Eigenschaften besitzen. In diesem Sinne sind derartigen Schichten primär als Transportschichten zu verstehen. Die Bezeichnung i-Schicht bezeichnet demgegenüber eine nominell undotierte Schicht (intrinsische Schicht). Eine oder mehrere i-Schichten können hierbei Schichten sowohl aus einem Material, als auch eine Mischung aus zwei Materialien (sogenannte interpenetrierende Netzwerke bzw. bulk-heterojunction; M. Hiramoto et al. Mol. Cryst. Liq. Cryst., 2006, 444, pp. 33-40) bestehen. Das durch den transparenten Grundkontakt einfallende Licht erzeugt in der i-Schicht bzw. in der n-/p-Schicht Exzitonen (gebundene Elektron-Loch-Paare). Diese Exzitonen können nur durch sehr hohe elektrische Felder oder an geeigneten Grenzflächen getrennt werden. In Organische Solarzellen stehen ausreichend hohe Felder nicht zur Verfügung, so dass alle Erfolg versprechenden Konzepte für organische Solarzellen auf der Exzitonentrennung an photoaktiven Grenzflächen beruhen. Die Exzitonen gelangen durch Diffusion an eine derartige aktive Grenzfläche, wo Elektronen und Löcher voneinander getrennt werden. Das Material, welches die Elektronen aufnimmt, wird dabei als Akzeptor, und das Material, welches das Loch aufnimmt, als Donator (oder Donor) bezeichnet. Die trennende Grenzfläche kann zwischen der p- (n-) Schicht und der i-Schicht bzw. zwischen zwei i-Schichten liegen. Im eingebauten elektrischen Feld der Solarzelle werden die Elektronen nun zum n-Gebiet und die Löcher zum p-Gebiet abtransportiert. Vorzugsweise handelt es sich bei den Transportschichten um transparente oder weitgehend transparente Materialien mit großer Bandlücke (wide-gap) wie sie z.B. in WO 2004083958 beschrieben sind. Als wide-gap Materialien werden hierbei Materialien bezeichnet, deren Absorptionsmaximum im Wellenlängenbereich < 450nm liegt, vorzugsweise bei < 400nm.

Da durch das Licht immer erst Exzitonen erzeugt werden und noch keine freien Ladungsträger, spielt die rekombinationsarme Diffusion von Exzitonen an die aktive Grenzfläche eine kritische Rolle bei Organische Solarzellen. Um einen Beitrag zum Photostrom zu leisten, muss daher in einer guten organischen Solarzelle die Exzitonendiffusionslänge die typische Eindringtiefe des Lichts deutlich übersteigen, damit der überwiegende Teil des Lichts genutzt werden kann. Strukturell und bezüglich der chemischen Reinheit perfekte organische Kristalle oder Dünnschichten erfüllen durchaus dieses Kriterium. Für großflächige Anwendungen ist allerdings die Verwendung von monokristallinen organischen Materialien nicht möglich und die Herstellung von Mehrfachschichten mit ausreichender struktureller Perfektion ist bis jetzt noch sehr schwierig.

[F. A. Castro u.a.: On the use of cyanine dyes as low-bandgap materials in bulk heterojunction photovoltaic devices. SYNTHETIC METALS, Vol. 156, No. 14-15, S. 973 - 978, 2006.] beschreibt die Verwendung von Flüssigfarbstoffe, die aus einer Lösung aufgebracht werden, als Materialien in fotovoltaischen Vorrichtungen. Dabei werden Photostromspektren für Vorrichtungen die MEH-PPV in Verbindung mit einem Flüssigfarbstoff gezeigt.

Falls es sich bei der i-Schicht um eine Mischschicht handelt, so übernimmt die Aufgabe der Lichtabsorption entweder nur eine der Komponenten oder auch beide. Der Vorteil von Mischschichten ist, dass die erzeugten Exzitonen nur einen sehr kurzen Weg zurücklegen müssen bis sie an eine Domänengrenze gelangen, wo sie getrennt werden. Der Abtransport der Elektronen bzw. Löcher erfolgt getrennt in den jeweiligen Materialien. Da in der Mischschicht die Materialien überall miteinander im Kontakt sind, ist bei diesem Konzept entscheidend, dass die getrennten Ladungen eine lange Lebensdauer auf dem jeweiligen Material besitzen und von jedem Ort aus geschlossene Perkolationspfade für beide Ladungsträgersorten zum jeweiligen Kontakt hin vorhanden sind.

Aus der US 5,093,698 ist die Dotierung organischer Materialien bekannt. Durch Beimischung einer akzeptorartigen bzw. donatorartigen Dotiersubstanz wird die Gleichgewichtsladungsträgerkonzentration in der Schicht erhöht und die Leitfähigkeit gesteigert. Nach US 5,093,698 werden die dotierten Schichten als Injektionsschichten an der Grenzfläche zu den Kontaktmaterialien in elektrolumineszierenden Bauelementen verwendet. Ähnliche Dotierungsansätze sind analog auch für Solarzellen zweckmäßig.

Aus der Literatur sind verschiedene Realisierungsmöglichkeiten für die photoaktive i-Schicht bekannt. So kann es sich hierbei um eine Doppelschicht (EP0000829) oder eine Mischschicht (Hiramoto, Appl. Phys.Lett. 58,1062 (1991)) handeln. Bekannt ist auch eine Kombination aus Doppel-und Mischschichten (Hiramoto, Appl. Phys.Lett. 58,1062 (1991); US 6,559,375). Ebenfalls bekannt ist, dass das Mischungsverhältnis in verschiedenen Bereichen der Mischschicht unterschiedlich ist (US 20050110005) bzw. das Mischungsverhältnis einen Gradienten aufweist.

[T. Yamanari u.a.: Dye-Sensitized Bulk Heterojunction Polymer Solar Cells", PHOTOVOLTAIC ENERGY CONVERSION, S. 240 - 243, 2006.] betrifft farbstoffsensibilisierte bulc-heterojunction-Polymersolarzellen als Einfachzelle, bei der Squarylium als Farbstoff zugegeben wird.

Weiterhin sind Tandem- bzw. Mehrfachsolarzellen aus der Literatur bekannt (Hiramoto, Chem. Lett.,1990, 327 (1990); DE 102004014046).

[Bruder, I. u.a.: "Efficient organic tandem cell combining a solid state dye-sensitized and a vacuum deposited bulk heterojunction solar cell", SOLAR ENERGY MATERIALS AND SOLAR CELLS, Vol. 93, No. 10, S. 1896 - 1899, 2009.] beschreibt eine Tandem-Solarzelle als Kombination einer ersten Teilzelle, die eine im Vakuum abgeschiedenen BHJ-Solarzelle mit ZnPc und C60 als aktiven Schicht repräsentiert, und einer zweiten Teilzelle die eine farbstoffsensibilisierte Feststoff-Solarzelle mit Np-TiO2/Indolinfarbstoff/Spiro-MeOTAD als aktive Schicht.

Weiterhin aus der Literatur bekannt sind organische pin-Tandemzellen (DE 102004014046): Die Struktur solch einer Tandemzelle besteht aus zwei pin-Einzelzellen wobei die Schichtfolge "pin" die Abfolge aus einem p-dotierten Schichtsystem, einem undotierten photoaktiven Schichtsystem und einem n-dotierten Schichtsystem beschreibt. Die dotierten Schichtsysteme bestehen bevorzugt aus transparenten Materialien, so genannten wide-gap Materialien/Schichten und sie können hierbei auch teilweise oder ganz undotiert sein oder auch ortsabhängig verschiedene Dotierungskonzentrationen aufweisen bzw. über einen kontinuierlichen Gradienten in der Dotierungskonzentration verfügen. Speziell auch sehr gering dotierte oder hochdotierte Bereiche im Grenzbereich an den Elektroden, im Grenzbereich zu einer anderen dotierten oder undotierten Transportschicht, im Grenzbereich zu den aktiven Schichten oder bei Tandem- oder Mehrfachzellen im Grenzbereich zu der anliegenden pin- bzw. nip- Teilzelle, d.h. im Bereich der Rekombinationszone sind möglich. Auch eine beliebige Kombination aus allen diesen Merkmalen ist möglich. Natürlich kann es sich bei einer solchen Tandemzelle auch um eine sogenannte invertierte Struktur (z.B. nip-Tandemzelle; handeln. Im Folgenden werden alle diese möglichen Tandemzellen-Realisierungsformen mit dem Begriff pin-Tandemzellen bezeichnet.

[Stolz, R. u.a: Trapping Light in Polymer photodiodes with soft embossed gratings. ADVANCED MATERIALS, Vol. 12, No. 3, S. 189 - 195, 2000.] beschreibt das Einfangen von Licht in Polymerfotodioden mit weichen eingestanzten Gittern.

Unter kleinen Molekülen werden im Sinne der vorliegenden Erfindung nicht-polymere organische Moleküle mit monodispersen Molmassen zwischen 100 und 2000 verstanden, die unter Normaldruck (Luftdruck der uns umgebenden Atmosphäre) und bei Raumtemperatur in fester Phase vorliegen. Insbesondere können diese kleinen Molekülen auch photoaktiv sein, wobei unter photoaktiv verstanden wird, dass die Moleküle unter Lichteinfall ihren Ladungszustand ändern.

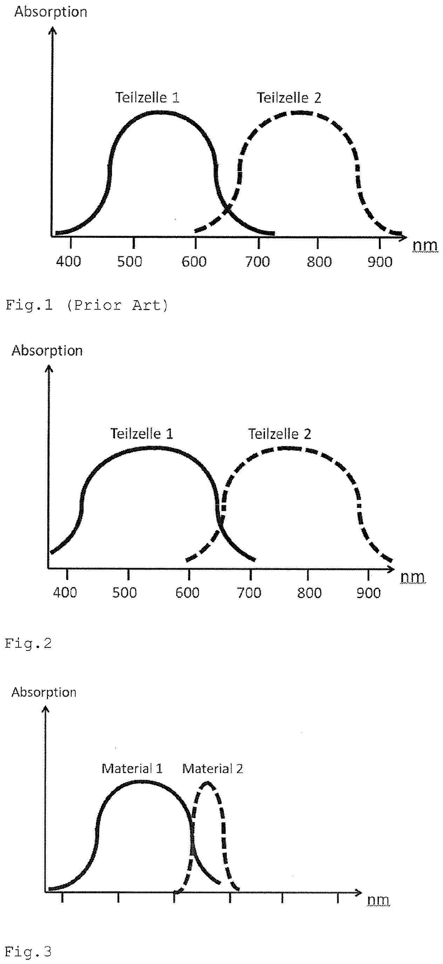

Das Problem von organischen Solarzellen ist derzeit, dass selbst die höchsten bisher im Labor erreichten Wirkungsgrade von 6 bis 7% noch zu gering sind. Für die meisten Anwendungen, speziell großflächige Anwendungen, wird ein Wirkungsgrad von ca. 10% als notwendig erachtet. Aufgrund der schlechteren Transporteigenschaften von organischen Halbleitern (im Vergleich zu anorganischen Halbleitern) und der damit verbundenen limitierten einsetzbaren Schichtdicken der Absorber in organischen Solarzellen geht man generell davon aus, dass solche Wirkungsgrade am ehesten mit Hilfe von Tandemzellen realisiert werden können (Tayebeh Ameri et al., Organic tandem solar cells: A review, Energy Environ. Sci., 2009, 2, 347-363; DE 10 2004 014 046.4). Speziell Wirkungsgrade bis zu 15% werden in Zukunft wohl nur mit Hilfe von Tandemzellen möglich sein. Der klassische Aufbau einer solchen Tandemsolarzelle ist dabei so, dass in den beiden Teilzellen verschiedene Absorbersysteme eingesetzt werden, die in verschiedenen Teilen (ggf. auch überlappend) des Sonnenspektrums absorbieren, um einen möglichst breiten Bereich auszunutzen. Das Absorbersystem der einen Teilzelle absorbiert hierbei im kürzerwelligen Spektralbereich (bevorzugt im sichtbaren Bereich) und das Absorbersystem der anderen Teilzelle im längerwelligen Spektralbereich (bevorzugt im Infrarot-Bereich). In der Fig. 1 ist die schematische Verteilung der Absorptionsspektren in den beiden Teilzellen einer Tandemzelle mit klassischem Aufbau dargestellt.

Der Nachteil dieser Tandemzellen liegt darin, dass die Teilzelle mit dem Infrarot-Absorber eine geringere Leerlaufspannung liefert als die andere Teilzelle und damit kann diese Teilzelle nur einen geringeren Beitrag zum Wirkungsgrad des Bauelementes leisten.

Die Aufgabe der vorliegenden Erfindung besteht daher darin, ein organisches photoaktives Bauelement anzugeben, welches die aufgezeigten Nachteile überwindet.

Erfindungsgemäß wird diese Aufgabe durch ein organisches photoaktives Bauelement gemäß dem Hauptanspruch gelöst. Vorteilhafte Ausgestaltungen sind in den abhängigen Ansprüchen angegeben.

Das erfindungsgemäße Bauelement, welches als Einfach-, Tandem- oder Mehrfachzelle ausgeführt ist, weist zwei Elektroden auf, wobei eine Elektrode auf einem Substrat und eine als Top-Gegenelektrode angeordnet ist. Zwischen den Elektroden ist ein photoaktives Akzeptor-Donator-Schichtsystem als Absorbersystem, welches zumindest drei Absorbermaterialien 1, 2, 3 aufweist. Dabei sind zumindest zwei Absorbermaterialien des photoaktiven Akzeptor-Donator-Schichsystems zumindest teilweise in einer Mischschicht vorhanden und zumindest Absorbermaterial 1 und Absorbermaterial 2 Donatoren und Akzeptormaterial 3 ein Azeptor ist oder Absorbermaterial 1 und Absorbermaterial 2 Akzeptoren sind und Absorbermaterial 3 ein Donator ist wobei eines der beiden als Donatoren oder Akzeptoren ausgebildeten Absorbermaterialien bei größeren Wellenlängen absorbiert als das andere Absorbermaterial, d. h. Absorbermaterial 2 absorbiert bei einer höheren Wellenlänge als Absorbermaterial 1 und wobei eines dieser beiden Absorbermaterialien (Absorbermaterial 2) einen geringeren Stokes-Shift und/oder eine geringere Absorptionsbreite im Film als das andere Absorbermaterial (Absorbermaterial 1) aufweist und wobei eines dieser beiden Absorbermaterialien gleichen Typs (Absorbermaterial 2) eine höhere Absorption, d.h. einen einen höheren Wert der optischen Dichte am Maximum, im Vergleich zum anderen Absorbermaterial (Absorbermaterial 1) aufweist.

Als Stokes-Shift wird im Sinne der Erfindung der Abstand in nm zwischen dem Maximum der Absorption und dem Maximum der Photolumineszenz definiert.

Als Donator wird ein Material bezeichnet, welches Elektronen abgibt. Als Akzeptor wird ein Material bezeichnet, welches Elektronen aufnimmt.

Als Absorbermaterialien werden dabei Materialien verstanden, die im Wellenlängenbereich von > 400nm absorbieren.

Als Absorptionsbreite bzw. Absorptionsbereich eines organischen Films wird hier die Halbwertsbreite (Breite bei 50% des lokalen Absorptionsmaximums)in nm eines lokalen Absorptionsmaximums verstanden oder die Breite des Absorptionsspektrums in nm bei dem Wert von 20% des lokalen Absorptionsmaximums. Im Sinne der Erfindung ist es, wenn zumindest eine der beiden Definitionen zutrifft.

In einer Ausführungsform der Erfindung weist das photoaktive Schichtsystem mindestens drei Absorbermaterialien 1,2,3 auf, wobei Absorbermaterial 1 und Absorbermaterial 2 Donatoren sind und Absorbermaterial 3 ein Akzeptor ist. Dabei weist das Absorbermaterial 2 einen geringeren Stokes-Shift als Absorbermaterial 1 auf.

In einer Ausführungsform der Erfindung weist das photoaktive Schichtsystem mindestens drei Absorbermaterialien 1,2,3 auf, wobei Absorbermaterial 1 und Absorbermaterial 2 Akzeptoren sind und Absorbermaterial 3 ein Donator ist. Dabei weist das Absorbermaterial 2 einen geringeren Stokes-Shift als Absorbermaterial 1 aufweist.

In einer Ausführungsform der Erfindung weist das photoaktive Schichtsystem mindestens drei Absorbermaterialien 1,2,3 auf, wobei Absorbermaterial 1 und Absorbermaterial 2 Donatoren sind und Absorbermaterial 3 ein Akzeptor ist. Dabei weist Absorbermaterial 2 eine geringere Absorptionsbreite als Absorbermaterial 1 auf.

In einer Ausführungsform der Erfindung weist das photoaktive Schichtsystem mindestens drei Absorbermaterialien 1,2,3 auf, wobei Absorbermaterial 1 und Absorbermaterial 2 Akzeptoren sind und Absorbermaterial 3 ein Donator ist. Dabei weist Absorbermaterial 2 eine geringere Absorptionsbreite als Absorbermaterial 1 auf.

In einer Ausführungsform der Erfindung besteht das Absorbersystem aus einem Donator-Akzeptor-System, wobei die Absorptionsbreite des Absorbersystems mindestens 200nm bis 250nm breit ist.

In einer Ausführungsform der Erfindung absorbiert eines der zumindest zwei Absorbermaterialien, welche als Donatoren oder Akzeptoren im Absorbersystem ausgebildet sind bei größeren Wellenlängen als das andere Absorbermaterial.

In einer Ausführungsform der Erfindung enthält das Absorbersystem dabei zumindest zwei Absorbermaterialien 1,2, wobei das zweite Absorbermaterial 2 bei größeren Wellenlängen absorbiert als das Absorbermaterial 1.

In einer Ausführungsform der Erfindung absorbiert das eine der zumindest zwei Absorbermaterialien, welche als Donatoren oder Akzeptoren im Absorbersystem ausgebildet sind bei kleineren Wellenlängen das andere Absorbermaterial.

In einer weiteren Ausführungsform der Erfindung hat das zweite Absorbermaterial 2 einen schmaleren Absorptionsbereich als das erste Absorbermaterial 1.

Der Vorteil dieses erfindungsgemäßen Aufbaus ist es, dass die Solarzellen eine höhere Leerlaufspannung bei gleichem Absorptionsbereich liefern können im Vergleich zum Stand der Technik.

Um nun insgesamt genügend Strom zu erzeugen, dass der Wirkungsgrad der Solarzelle 10% oder mehr betragen kann, müssen die Absorptionsbreiten der jeweiligen Absorbersysteme in Tandem- oder Mehrfachzellen mindestens 200nm bis 250nm breit sein. So kann z.B. eine Teilzelle von 400nm bis 650nm absorbieren und die andere Teilzelle von 650nm bis 900nm (Fig. 2).

In einer weiteren Ausführungsform der Erfindung ist das Bauelement als organische pin-Solarzelle bzw. organische pin-Tandemsolarzelle ausgeführt. Als Tandemsolarzelle wird dabei eine Solarzelle bezeichnet, die aus einem vertikalen Stapel zweier in Serie verschalteter Solarzellen besteht.

In einer Ausführungsform der Erfindung sind das erste Absorbermaterial 1 und das zweite Absorbermaterial 2 entweder beide Donatoren oder beide Akzeptoren.

In einer weiteren Ausführungsform der Erfindung hat das zweite Absorbermaterial 2 einen geringeren Stokes-Shift als das erste Absorbermaterial 1.

In einer weiteren Ausführungsform der Erfindung sind das erste Absorbermaterial 1 und/oder das zweite Absorbermaterial 2 zumindest teilweise in einer Mischschicht vorhanden.

In einer weiteren Ausführungsform der Erfindung sind mindestens zwei Absorbermaterialien des Absorbersystems zumindest teilweise in einer Mischschicht vorhanden.

In einer weiteren Ausführungsform der Erfindung unterscheiden sich die HOMO-Lagen des eines der zumindest zwei Absorbermaterialien, welche als Donatoren oder Akzeptoren im Absorbersystem ausgebildet sind, um maximal 0,2eV vom anderen Absorbermaterial, bevorzugt um maximal 0,1eV. So unterscheiden sich beispielsweise die HOMO-Lagen des Absorbermaterial 2 und des Absorbermaterial 1 maximal um 0,2eV, bevorzugt um maximal 0,1eV. Falls das Absorbermaterial 2 bei längeren Wellenlängen als das Absorbermaterial 1 absorbiert, so wird im allgemeinen das Absorbermaterial 2 die Leerlaufspannung begrenzen und es sollte die HOMO-Lage des Absorbermaterials 2 nicht wesentlich höher liegen als für das Absorbermaterial 1, um nicht noch unnötig Spannung zu verlieren.

In einer weiteren Ausführungsform der Erfindung sind in dem Bauelement noch eine oder mehrere undotierte, teilweise dotierte oder ganz dotierte Transportschichten vorhanden. Bevorzugt haben diese Transportschichten ein Maximum der Absorption bei < 450nm, sehr bevorzugt < 400nm.

In einer weiteren Ausführungsform der Erfindung ist zumindest ein weiteres Absorbermaterial (Absorbermaterial 3) im Absorbersystem vorhanden und zwei oder mehr der Absorbermaterialien 1, 2 und 3 weisen verschiedene optische Absorptionsspektren auf, die sich gegenseitig ergänzen, um einen möglichst breiten Spektralbereich abzudecken.

In einer weiteren Ausführungsform der Erfindung erstreckt sich der Absorptionsbereich zumindest eines der Absorbermaterialien 1, 2 oder 3 in den Infrarot-Bereich im Wellenlängenbereich von >700nm bis 1500nm.

In einer weiteren Ausführungsform der Erfindung ist mindestens eines der Absorbermaterialien ein 1, 2 oder 3 ein Absorbermaterial ausgewählt aus der Klasse bestehend aus Fullerene bzw. Fullerenderivate, Phthalocyanine, Perylenderivate, TPD-Derivate oder Oligothiophen-Derivate.

In einer weiteren Ausführungsform der Erfindung besteht das Bauelement aus einer Tandem- oder Mehrfachzelle. Bevorzugt besteht das Bauelement aus einer Kombination aus nip, ni, ip, pnip, pni, pip, nipn, nin, ipn, pnipn, pnin oder pipn-Strukturen, bei der mehrere unabhängige Kombinationen, die mindestens eine i-Schicht enthalten, übereinander gestapelt sind.

In einer weiteren Ausführungsform der Erfindung sind die Schichten des Schichtsystems des Bauelements als eine den optischen Weg des einfallenden Lichts verlängernde Lichtfalle ausgebildet.

In einer weiteren Ausführungsform der Erfindung handelt es sich bei den verwendeten organischen Materialien um kleine Moleküle. Unter kleinen Molekülen werden im Sinne der vorliegenden Erfindung nicht-polymere organische Moleküle mit monodispersen Molmassen zwischen 100 und 2000 verstanden, die unter Normaldruck (Luftdruck der uns umgebenden Atmosphäre) und bei Raumtemperatur in fester Phase vorliegen. Insbesondere könnend diese kleinen Molekülen auch photoaktiv sein, wobei unter photoaktiv verstanden wird, dass die Moleküle unter Lichteinfall ihren Ladungszustand ändern.

In einer weiteren Ausführungsform der Erfindung handelt es sich bei den verwendeten organischen Materialien zumindest teilweise um Polymere.

In einer weiteren Ausführungsform der Erfindung bestehen die organischen Schichten zumindest teilweise aus kleinen Molekülen, zumindest teilweise aus Polymeren oder aus einer Kombination von kleinen Molekülen und Polymeren.

In einer weiteren Ausführungsform der Erfindung ist das Bauelement zumindest in einem gewissen Lichtwellenlängenbereich semitransparent.

In einer weiteren Ausführungsform der Erfindung wird das Bauelement auf ebenen, gekrümmten oder flexiblen Trägerflächen verwendet. Bevorzugt sind diese Trägerflächen Plastikfolien oder Metallfolien (z.B. Aluminium, Stahl), etc..

In einer weiteren Ausführungsform der Erfindung wird das Bauelement als Tandemzelle realisiert. Bei Tandemzellen ist es wichtig, dass beide Teilzellen gleich viel absorbieren bzw. gleich viel Strom erzeugen. Falls nämlich die Absorption in einer Teilzelle zu schmal ist, so erzeugt die betreffende Teilzelle nicht genügend Strom, und da in einer Tandemzelle der geringere Strom limitiert ist, so hat das gesamte Bauelement einen kleineren Wirkungsgrad. Das Problem bei einem organischen Absorber mit einer breiteren Absorption ist allerdings, dass dann auch die Photolumineszenz weiter verschoben ist und der Stokes-Shift größer ist. Ein größerer Stokes-Shift bedeutet aber ein größerer Energieverlust im Material (aufgrund von Reorganisationsprozessen; die Lage der Photolumineszenz ist ein Gradmesser dafür, wie viel Energie im System vorhanden ist). Dies bedeutet letztendlich, dass nur eine kleinere Leerlaufspannung mit Materialien mit einer breiteren Absorption erreichbar ist (bei gleicher maximaler Absorptionswellenlänge). Hiermit ergibt sich nun direkt ein Problem für Infrarot-Absorber: Aufgrund der geringen Bandlücke ist die erreichbare Leerlaufspannung sowieso schon geringer. Damit jetzt aber die Teilzelle mit dem Infrarot-Absorbersystem genauso viel Strom erzeugt wie die andere Teilzelle, muss der Infrarot-Absorber ebenfalls eine breite Absorption besitzen, womit sich insgesamt eine sehr kleine Leerlaufspannung ergibt. Dies führt dazu, dass mit einem solchen System das Ziel von 10% Effizienz wenn überhaupt nur sehr schwierig erreichbar ist. In einer Ausführungsform der Erfindung wird dieses Problem dadurch gelöst, dass das Absorbersystem aus einer Kombination besteht aus einem breit-absorbierenden Material (Material 1), welches bei kürzeren Wellenlängen (bevorzugt VIS) absorbiert und damit eine größere Leerlaufspannung liefern kann, und aus einem schmal-absorbierenden Material (Material 2), welches bei längeren Wellenlängen (bevorzugt Infrarot) absorbiert, aber aufgrund des geringen Stokes-Shiftes ebenfalls die gleich große Leerlaufspannung liefern kann wie das Material 1 (Fig. 3).

In einer Ausführungsform der Erfindung ist die Absorptionsbreite von Absorbermaterial 2 20nm bis 250 nm schmaler als die Absorptionsbreite von Absorbermaterial 1, besonders bevorzugt 50nm bis 100nm.

In einer Ausführungsform der Erfindung verfügt das zweite Absorbermaterial 2 über eine höhere bzw. sehr hohe Absorption (Wert der optischen Dichte am Maximum) im Vergleich zum ersten Absorbermaterial 1.

In einer Ausführungsform der Erfindung beinhaltet der bevorzugte Aufbau eines erfindungsgemäßen photoaktiven Bauelements eine Kombination aus einem breit-absorbierenden Absorbermaterial (Material 1), welches bei kürzeren Wellenlängen (bevorzugt VIS) absorbiert und aus einem schmal-absorbierenden Absorbermaterial (Material 2), welches bei längeren Wellenlängen (bevorzugt Infrarot) absorbiert. Hierbei können die Materialien 1 bzw. 2 als Einzelschichten bzw. als Mischschichten vorliegen bzw. beliebige Kombinationen vorhanden sein.

In einer Ausführungsform der Erfindung sind beide Absorbermaterialien 1 und 2 entweder Donatoren oder Akzeptoren. Das Absorbersystem besteht aus mindestens drei Absorbermaterialien, wobei Absorbermaterial 3 ein Donator ist, für den Fall das Absorbermaterial 1 und 2 Akzeptoren sind bzw. Absorbermaterial 3 ein Akzeptor ist, falls Absorbermaterial 1 und 2 Donatoren sind.

Das Absorbersystem eines erfindungsgemäßen photoaktiven Bauelements in der Realisierung als Einfachzelle kann eine der folgenden Aufbauten haben, worin ES=Einzelschicht und MS=Mischschicht bedeutet:
ES Material 1 / ES Material 2 / ES Material 3
ES Material 2 / ES Material 1 / ES Material 3
MS Material 1 / ES Material 2
MS Material 1 / ES Material 2 / ES Material 3
ES Material 3 / MS Material 1 / ES Material 2
MS Material 2 / ES Material 1
MS Material 2 / ES Material 1 / ES Material 3
ES Material 3 / MS Material 2 / ES Material 1
MS Material 1 / MS Material 2
MS Material 1 / MS Material 2 / ES Material 3
MS Material 2 / MS Material 1 / ES Material 3
Dreiermischschicht aus Material 1, 2 und 3

In einer Ausführungsform der Erfindung wird ein erfindungsgemäßes photoaktives Bauelement in der Realisierung als Tandem- oder Mehrfachzelle wie folgt realisiert:
Die erste Teilzelle enthält eine Kombination aus einem breit-absorbierenden Material (Material 1) und aus einem schmal-absorbierenden Material (Material 2), welches bei längeren Wellenlängen absorbiert als Material 1
und
die zweite Teilzelle enthält eine Kombination aus einem breit-absorbierenden Material (Material 4) und aus einem schmal-absorbierenden Material (Material 5), welches bei längeren Wellenlängen absorbiert als Material 4.

In einer Ausführungsform der Erfindung absorbieren Material 1 und 2 im sichtbaren Wellenlängenbereich (VIS) und Material 4 und 5 im infraroten Bereich (IR).

Die Tandemzelle absorbiert damit jeweils in beiden Teilzellen sowohl im VIS als auch im IR-Bereich und deckt damit wiederum wie in der klassischen Tandemstruktur einen breiten Bereich des Sonnenspektrums ab (bevorzugt von 400nm bis 900nm) und liefert damit einen großen Strom. Aufgrund des speziellen erfindungsgemäßen Aufbaus dieser Tandemzellen können aber beide Teilzellen eine große Leerlaufspannung liefern und der Wirkungsgrad liegt damit höher im Vergleich zu einer Tandemzelle mit dem klassischen Aufbau.

In einer Ausführungsform der Erfindung sind in einer erfindungsgemäßen Tandemzelle beide Materialien 1 und 2 bzw. 4 und 5 jeweils entweder Donatoren oder Akzeptoren. Z.B. kann das Absorbersystem 1 der Teilzelle 1 eine der folgenden Aufbauten haben (ES=Einzelschicht; MS=Mischschicht; material):
ES Material 1 / ES Material 2 / ES Material 3
ES Material 2 / ES Material 1 / ES Material 3
MS Material 1 / ES Material 2
MS Material 1 / ES Material 2 / ES Material 3
ES Material 3 / MS Material 1 / ES Material 2
MS Material 2 / ES Material 1
MS Material 2 / ES Material 1 / ES Material 3
ES Material 3 / MS Material 2 / ES Material 1
MS Material 1 / MS Material 2
MS Material 1 / MS Material 2 / ES Material 3
MS Material 2 / MS Material 1 / ES Material 3
Dreiermischschicht aus Material 1, 2 und 3

Und das Absorbersystem 2 der Teilzelle2 kann folgenden Aufbau haben:
ES Material 4 / ES Material 5 / ES Material 6
ES Material 5 / ES Material 4 / ES Material 6
MS Material 4 / ES Material 5
MS Material 4 / ES Material 5 / ES Material 6
ES Material 6 / MS Material 4 / ES Material 5
MS Material 5 / ES Material 4
MS Material 5 / ES Material 4 / ES Material 6
ES Material 6 / MS Material 5 / ES Material 4
MS Material 4 / MS Material 5
MS Material 4 / MS Material 5 / ES Material 6
MS Material 5 / MS Material 4 / ES Material 6
Dreiermischschicht aus Material 4, 5 und 6

In einer Ausführungsform der Erfindung ist das Material 6 ein Donator, falls Material 4 und 5 Akzeptoren sind bzw. Material 6 ist ein Akzeptor, falls Material 4 und 5 Donatoren sind.

In einer Ausführungsform der Erfindung können die Materialien 3 und 6 auch identisch sein. Auch können eine oder mehrere der Materialien 1,2,4 und 5 identisch sein.

Die Tandemzelle oder Mehrfachzelle aus mehr als zwei Teilzellen kann dann eine beliebige Kombination aus den obigen Aufbauten der Teilzellen 1 und 2 sein.

In einer weiteren Ausführungsform der Erfindung enthält mindestens eine der photoaktiven Mischschichten als Akzeptor ein Material aus der Gruppe der Fullerene bzw. Fullerenderivate (C₆₀, C₇₀, etc.).

In einer weiteren Ausführungsform der Erfindung enthält mindestens eine der photoaktiven Mischschichten als Donator ein Material aus der Klasse der Phthalocyanine, Perylenderivate, TPD-Derivate, Oligothiophene oder ein Material wie es in WO2006092134 beschrieben ist.

In einer weiteren Ausführungsform der Erfindung enthält mindestens eine der photoaktiven Mischschichten als Akzeptor das Material Fulleren C₆₀ und als Donator das Material 4P-TPD.

In einer weiteren Ausführungsform der Erfindung bestehen die Kontakte aus Metall, einem leitfähigen Oxid, insbesondere ITO, ZnO:Al oder anderen TCOs oder einem leitfähigen Polymer, insbesondere PEDOT:PSS oder PANI.

In Mehrfachmischschichtsystemen treten vermehrt Transportprobleme für die Ladungsträger auf. Dieser Abtransport wird durch das eingebaute Feld der pin-Struktur deutlich erleichtert. Weiterhin können die Mehrfachmischschichten innerhalb einer pin-Struktur mit dotierten wide-gap Transportschichten verschoben werden, um eine optimale Absorption zu erzielen. Hierfür kann es auch sehr vorteilhaft sein, die pin-Struktur in eine nip-Struktur zu verändern. Speziell wenn die verschiedenen Materialien in den Mehrfachmischschichten in verschiedenen Wellenlängenbereichen absorbieren, können durch eine geeignete Wahl der Struktur (pin oder nip) bzw. eine geeignete Wahl der Schichtdicken der Transportschichten die verschiedenen Materialien jeweils an die optimale Position hinsichtlich der Intensitätsverteilung des Lichtes innerhalb des Bauelementes positioniert werden. Speziell bei Tandemzellen ist diese Optimierung sehr wichtig um einen Ausgleich der Photoströme der Einzelzellen zu erreichen und somit einen maximalen Wirkungsgrad zu erreichen.

Eine weitere Ausführungsform des erfindungsgemäßen Bauelementes besteht darin, dass zwischen der ersten elektronenleitenden Schicht (n-Schicht) und der auf dem Substrat befindlichen Elektrode noch eine p-dotierte Schicht vorhanden ist, so dass es sich um eine pnip oder pni-Struktur handelt, wobei vorzugsweise die Dotierung so hoch gewählt ist, dass der direkte pn-Kontakt keine sperrende Wirkung hat, sondern es zu verlustarmer Rekombination, bevorzugt durch einen Tunnelprozess kommt.

In einer weiteren Ausführungsform der Erfindung kann in dem Bauelement zwischen der photoaktiven i-Schicht und der auf dem Substrat befindlichen Elektrode noch eine p-dotierte Schicht vorhanden sein, so dass es sich um eine pip oder pi-Struktur handelt, wobei die zusätzliche p-dotierte Schicht eine Ferminiveaulage hat, die höchstens 0,4eV, bevorzugt aber weniger als 0,3eV unterhalb des Elektronentransportniveaus der i-Schicht liegt, so dass es zu verlustarmer Elektronenextraktion aus der i-Schicht in diese p-Schicht kommen kann.

Eine weitere Ausführungsform des erfindungsgemäßen Bauelementes besteht darin, dass noch ein n-Schichtsystem zwischen der p-dotierten Schicht und der Gegenelektrode vorhanden ist, so dass es sich um eine nipn oder ipn-Struktur handelt, wobei vorzugsweise die Dotierung so hoch gewählt ist, dass der direkte pn-Kontakt keine sperrende Wirkung hat, sondern es zu verlustarmer Rekombination, bevorzugt durch einen Tunnelprozess kommt.

In einer weiteren Ausführungsform kann in dem Bauelement noch ein n-Schichtsystem zwischen der intrinsischen, photoaktiven Schicht und der Gegenelektrode vorhanden sein, so dass es sich um eine nin- oder in-Struktur handelt, wobei die zusätzliche n-dotierte Schicht eine Ferminiveaulage hat, die höchstens 0,4eV, bevorzugt aber weniger als 0,3eV oberhalb des Löchertransportnivaus der i-Schicht liegt, so dass es zu verlustarmer Löcherextraktion aus der i-Schicht in diese n-Schicht kommen kann.

Eine weitere Ausführungsform des erfindungsgemäßen Bauelementes besteht darin, dass das Bauelement ein n-Schichtsystem und/oder ein p-Schichtsystem enthält, so dass es sich um eine pnipn, pnin, pipn- oder p-i-n-Struktur handelt, die sich in allen Fällen dadurch auszeichnen, dass - unabhängig vom Leitungstyp - die substratseitig an die photoaktive i-Schicht angrenzende Schicht eine geringere thermische Austrittsarbeit hat als die vom Substrat abgewandte an die i-Schicht grenzende Schicht, so dass photogenerierte Elektronen bevorzugt zum Substrat hin abtransportiert werden, wenn keine externe Spannung an das Bauelement angelegt wird.

In einer bevorzugten Weiterbildung der oben beschriebenen Strukturen sind diese als organische Tandemsolarzelle oder Mehrfachsolarzelle ausgeführt. So kann es sich bei dem Bauelement um eine Tandemzelle aus einer Kombination aus nip, ni, ip, pnip, pni, pip, nipn, nin, ipn, pnipn, pnin oder pipn-Strukturen handeln, bei der mehrere unabhängige Kombinationen, die mindestens eine i-Schicht enthalten, übereinander gestapelt sind (Kreuzkombinationen).

In einer besonders bevorzugten Ausführungsform der oben beschriebenen Strukturen ist diese als eine pnipnipn-Tandemzelle ausgeführt.

In einer weiteren Ausführungsform liegt das Akzeptor-Material in der Mischschicht zumindest teilweise in kristalliner Form vor.

In einer weiteren Ausführungsform liegt das Donator-Material in der Mischschicht zumindest teilweise in kristalliner Form vor.

In einer weiteren Ausführungsform liegen sowohl das Akzeptor-Material als auch das Donator-Material in der Mischschicht zumindest teilweise in kristalliner Form vor.

In einer weiteren Ausführungsform verfügt das Akzeptor-Material über ein Absorptionsmaximum im Wellenlängenbereich > 450nm.

In einer weiteren Ausführungsform verfügt das Donator-Material über ein Absorptionsmaximum im Wellenlängenbereich > 450nm.

In einer weiteren Ausführungsform enthält das photoaktive i-Schichtsystem zusätzlich zu der genannten Mischschicht noch weitere photoaktive Einzel- oder Mischschichten.

In einer weiteren Ausführungsform besteht das n-Materialsystem aus einer oder mehreren Schichten.

In einer weiteren Ausführungsform besteht das p-Materialsystem aus einer oder mehreren Schichten.

In einer weiteren Ausführungsform ist das Donator-Material ein Oligomer, insbesondere ein Oligomer nach WO2006092134, ein Porphyrin-Derivat, ein Pentacen-Derivat oder ein Perylenderivat, wie DIP (Di-Indeno-Perylen), DBP (Di-benzoperylene).

In einer weiteren Ausführungsform enthält das p-Materialsystem ein TPD-Derivat(Triphenylamin-Dimer), eine Spiro-Verbindung, wie Spiropyrane, Spiroxazine, MeO-TPD (N,N,N',N'-Tetrakis(4-methoxyphenyl)-benzidin), Di-NPB (N,N'diphenyl-N,N'-bis(N,N'-di(1-naphthyl)-N,N'-diphenyl-(1,1'-biphenyl) 4,4'-diamine), MTDATA (4,4',4"-Tris-(N-3-methylphenyl-N-phenyl-amino)-triphenylamin), TNATA (4,4',4"-Tris[N-(1-naphthyl)-N-phenyl-amino]-triphenylamin), BPAPF (9,9-bis{4-[di-(p-biphenyl)aminophenyl]}fluorene), NPAPF (9,9-Bis[4-(N,N'-bis-naphthalen-2-yl-amino)phenyl]-9H-fluorene), Spiro-TAD (2,2',7,7'-Tetrakis-(diphenylamino)-9,9'-spirobifluoren), PV-TPD (N,N-di 4-2,2-diphenyl-ethen-1-yl-phenyl-N,N-di 4-methylphenylphenylbenzidine), 4P-TPD (4,4'-bis-(N,N-diphenylamino)-tetraphenyl), oder ein in DE102004014046 beschriebenes p-Material.

In einer weiteren Ausführungsform enthält das n-Materialsystem Fullerene, wie beispielsweise C60, C70; NTCDA (1,4,5,8-Naphthalene-tetracarboxylic-dianhydride), NTCDI (Naphthalenetetracarboxylic diimide) oder PTCDI (Perylen-3,4,9,10-bis(dicarboximid).

In einer weiteren Ausführungsform enthält das p-Materialsystem einen p-Dotanden, wobei dieser p-Dotand F4-TCNQ, ein p-Dotand wie in DE10338406, DE10347856, DE10357044, DE102004010954, DE102006053320, DE102006054524 und DE102008051737 beschrieben oder ein Übergangsmetalloxid (VO, WO, MoO, etc.) ist.

In einer weiteren Ausführungsform enthält das n-Materialsystem einen n-Dotanden, wobei dieser n-Dotand ein TTF-Derivat (Tetrathiafulvalen-Derivat) oder DTT-Derivat (Dithienothiophen), ein n-Dotand wie in DE10338406, DE10347856, DE10357044, DE102004010954, DE102006053320, DE102006054524 und DE102008051737 beschrieben oder Cs, Li oder Mg ist.

In einer weiteren Ausführungsform ist eine Elektrode transparent mit einer Transmission > 80% und die andere Elektrode reflektierend mit einer Reflektion > 50% ausgeführt.

In einer weiteren Ausführungsform ist das Bauelement semitransparent mit einer Transmission von 10-80% ausgeführt.

In einer weiteren Ausführungsform bestehen die Elektroden aus einem Metall (z.B. Al, Ag, Au oder eine Kombination aus diesen), einem leitfähigen Oxid, insbesondere ITO, ZnO:Al oder einem anderen TCO (Transparent Conductive Oxide), einem leitfähigen Polymer, insbesondere PEDOT/PSS Poly(3,4-ethylenedioxythiophene)poly(styrenesulfonate) oder PANI (Polyanilin), oder aus einer Kombination aus diesen Materialien.

In einer weiteren Ausführungsform wird die Lichtfalle dadurch realisiert, dass das Bauelement auf einem periodisch mikrostrukturierten Substrat aufgebaut wird und die homogene Funktion des Bauelements, also eine kurzschlussfreie Kontaktierung und homogene Verteilung des elektrischen Feldes über die gesamte Fläche, durch die Verwendung einer dotierten wide-gap-Schicht gewährleistet wird. Ultradünne Bauelemente weisen auf strukturierten Substraten eine erhöhten Gefahr zur Bildung lokaler Kurzschlüsse auf, so dass durch eine solche offensichtliche Inhomogenität letztlich die Funktionalität des gesamten Bauelements gefährdet ist. Diese Kurzschlussgefahr wird durch die Verwendung der dotierten Transportschichten verringert.

In einer weiteren Ausführungsform der Erfindung wird die Lichtfalle dadurch realisiert, dass das Bauelement auf einem periodisch mikrostrukturierten Substrat aufgebaut wird und die homogene Funktion des Bauelementes, dessen kurzschlussfreie Kontaktierung und eine homogene Verteilung des elektrischen Feldes über die gesamte Fläche durch die Verwendung einer dotierten wide-gap-Schicht gewährleistet wird. Besonders vorteilhaft ist dabei, dass das Licht die Absorberschicht mindestens zweimal durchläuft, was zu einer erhöhten Lichtabsorption und dadurch zu einem verbesserten Wirkungsgrad der Solarzelle führen kann. Dies lässt sich beispielsweise dadurch erreichen, dass das Substrat pyramidenartige Strukturen auf der Oberfläche aufweist mit Höhen (h) und Breiten (d) jeweils im Bereich von einem bis zu mehreren hundert Mikrometern. Höhe und Breite können gleich oder unterschiedlich gewählt werden. Ebenfalls können die Pyramiden symmetrisch oder asymmetrisch aufgebaut sein.

In einer weiteren Ausführungsform der Erfindung wird die Lichtfalle dadurch realisiert, dass eine dotierte wide-gap-Schicht eine glatte Grenzfläche zur i-Schicht und eine rauhe Grenzfläche zum reflektierenden Kontakt hat. Die rauhe Grenzfläche kann beispielsweise durch eine periodische Mikrostrukturierung erreicht werden. Besonders vorteilhaft ist die rauhe Grenzfläche, wenn sie das Licht diffus reflektiert, was zu einer Verlängerung des Lichtweges innerhalb der photoaktiven Schicht führt.

In einer weiteren Ausführungsform wird die Lichtfalle dadurch realisiert, dass das Bauelement auf einem periodisch mikrostrukturierten Substrat aufgebaut wird und eine dotierte wide-gap-Schicht eine glatte Grenzfläche zur i-Schicht und eine rauhe Grenzfläche zum reflektierenden Kontakt hat.

In einer weiteren Ausführungsform der Erfindung ist die Gesamtstruktur mit transparentem Grund- und Deckkontakt versehen.

In einer weiteren Ausführungsform der Erfindung besteht das photoaktive Bauelement, insbesondere eine organische Solarzelle, aus einer Elektrode und einer Gegenelektrode und zwischen den Elektroden wenigstens zwei organische photoaktive Mischschichten, wobei die Mischschichten jeweils mindestens zwei Materialien umfassen und die beiden Hauptmaterialien jeweils einer Mischschicht zumindest ein Absorbersystem bestehend aus einem Donator-Akzeptor-System aufweist, wobei die Absorptionsbreite des Absorbersystems mindestens 200nm bis 250nm breit ist. Das Absorbersystem enthält dabei zumindest zwei Absorbermaterialien (Material 1 und 2), wobei Material 2 bei größeren Wellenlängen absorbiert als Material 1 und Material 2 einen schmaleren Absorptionsbereich hat als Material 1.

In einer weiteren Ausführungsform grenzen die beiden Mischschichten direkt aneinander, wobei wenigstens eine der beiden Hauptmaterialien der einen Mischschicht ein anderes organisches Material ist als die beiden Hauptmaterialien einer anderen Mischschicht.

In einer Weiterbildung der vorbeschriebenen Ausführungsform sind mehrere oder alle Hauptmaterialien der Mischschichten voneinander verschieden.

In einer weiteren Ausführungsform der Erfindung handelt es sich um drei oder mehr Mischschichten, welche zwischen der Elektrode und Gegenelektrode angeordnet sind.

In einer weiteren Ausführungsform der Erfindung sind zusätzlich zu den genannten Mischschichten noch weitere photoaktive Einzel- oder Mischschichten vorhanden.

In einer weiteren Ausführungsform der Erfindung ist zwischen dem Mischschichtsystem und der einen Elektrode noch wenigstens eine weitere organische Schicht vorhanden.

In einer weiteren Ausführungsform der Erfindung ist zwischen dem Mischschichtsystem und der Gegenelektrode noch wenigstens eine weitere organische Schicht vorhanden.

In einer weiteren Ausführungsform der Erfindung sind eine oder mehrere der weiteren organischen Schichten dotierte wide-gap Schichten, wobei das Maximum der Absorption bei < 450nm liegt.

In einer weiteren Ausführungsform der Erfindung weisen mindestens zwei Hauptmaterialien der Mischschichten verschiedene optische Absorptionsspektren auf.

In einer weiteren Ausführungsform der Erfindung weisen die Hauptmaterialien der Mischschichten verschiedene optische Absorptionsspektren auf, die sich gegenseitig ergänzen, um einen möglichst breiten Spektralbereich abzudecken.

In einer weiteren Ausführungsform der Erfindung erstreckt sich der Absorptionsbereich zumindest eines der Hauptmaterialien der Mischschichten in den Infrarot-Bereich.

In einer weiteren Ausführungsform der Erfindung erstreckt sich der Absorptionsbereich zumindest eines der Hauptmaterialien der Mischschichten in den Infrarot-Bereich im Wellenlängenbereich von > 700nm bis 1500nm.

In einer weiteren Ausführungsform der Erfindung sind die HOMO-und LUMO-Niveaus der Hauptmaterialien so angepasst, dass das System eine maximale Leerlaufspannung, einen maximalen Kurzschlussstrom und einen maximalen Füllfaktor ermöglicht.

In einer weiteren Ausführungsform der Erfindung ist die Gesamtstruktur mit transparentem Grund- und Deckkontakt versehen.

In einer weiteren Ausführungsform werden die erfindungsgemäßen photoaktiven Bauelemente auf gekrümmten Oberflächen, wie beispielsweise Beton, Dachziegeln, Ton, Autoglas, etc. verwendet. Dabei ist es vorteilhaft, dass die erfindungsgemäßen organischen Solarzellen gegenüber herkömmlichen anorganischen Solarzellen auf flexiblen Trägern wie Folien, Textilen, etc. aufgebracht werden können.

In einer weiteren Ausführungsform werden die erfindungsgemäßen photoaktiven Bauelemente auf eine Folie oder Textil aufgebracht, welche auf der, mit dem erfindungsgemäßen organischen Schichtsystem gegenüberliegenden Seite ein Adhäsionsmittel, wie beispielsweise einen Klebstoff aufweist. Dadurch ist es möglich eine Solarklebefolie herzustellen, welche nach Bedarf auf beliebigen Oberflächen angeordnet werden kann. So kann eine selbsthaftende Solarzelle erzeugt werden.

In einer weiteren Ausführungsform weisen die erfindungsgemäßen photoaktiven Bauelemente ein anderes Adhäsionsmittel in Form einer Klettverschlussverbindung auf.

In einer weiteren Ausführungsform werden die erfindungsgemäßen photoaktiven Bauelemente in Verbindung mit Energiepuffer bzw. Energiespeichermedium wie beispielsweise Akkus, Kondensatoren, etc. zum Anschluss an Verbraucher bzw. Geräte verwendet.

In einer weiteren Ausführungsform werden die erfindungsgemäßen photoaktiven Bauelemente in Kombination mit Dünnfilmbatterien verwendet.

Nachfolgend soll die Erfindung eingehender erläutert werden. Es zeigen in
Fig. 1 eine schematische Darstellung der Verteilung der Absorptionsspektren in den beiden Teilzellen einer Tandemzelle mit klassischem Aufbau nach dem Stand der Technik, in
Fig. 2, eine schematische Darstellung der Verteilung der Absorptionsspektren in den beiden Teilzellen in einer erfindungsgemäßen Tandemzelle, wobei die Absorptionsbreiten der jeweiligen Absorbersysteme mindestens 200nm bis 250nm breit sind, in
Fig. 3 eine beispielhafte schematische Darstellung eines möglichen Verlaufs der Absorptionsspektren von Material 1 und 2 in einer erfindungsgemäßen Einzelzelle, in
Fig. 4 eine beispielhafte schematische Darstellung eines möglichen Verlaufs der Absorptions- und Photolumineszensspektren eines Materials 1 und eines Materials 2 in einer erfindungsgemäßen Einzelzelle, in
Fig. 5 eine beispielhafte schematische Darstellung eines möglichen Verlaufs der Absorptionsspektren von Material 1 und 2 in einer erfindungsgemäßen Einzelzelle, wobei das Material 2 über eine höhere bzw. sehr hohe Absorption (Wert der optischen Dichte am Maximum) im Vergleich zu Material 1 verfügt, in
Fig. 6 eine beispielhafte schematische Darstellung der Verteilung der Absorptionsspektren der vier Materialien in den beiden Teilzellen in einer erfindungsgemäßen Tandemzelle, in
Fig. 7 eine beispielhafte schematische Darstellung der Verteilung der Absorptionsspektren der vier Materialien in den beiden Teilzellen in einer erfindungsgemäßen Tandemzelle, wobei die Materialien 4 und 5 eine höhere Absorption als die Materialien 1 und 2 aufweisen, in
Fig. 8 eine weitere beispielhafte schematische Darstellung der Verteilung der Absorptionsspektren der vier Materialien in den beiden Teilzellen in einer erfindungsgemäßen Tandemzelle, in
Fig. 9 eine weitere beispielhafte schematische Darstellung der Verteilung der Absorptionsspektren der vier Materialien in den beiden Teilzellen in einer erfindungsgemäßen Tandemzelle, wobei die die Materialien 2 und 5 eine höhere Absorption als die Materialien 1 und 4 aufweisen, in
Fig. 10 eine weitere beispielhafte schematische Darstellung der Verteilung der Absorptionsspektren der vier Materialien in den beiden Teilzellen in einer erfindungsgemäßen Tandemzelle, wobei die vier Materialien eine breiten Bereich des Sonnenspektrums abdecken, in
Fig. 11 die schematische Darstellung einer Struktur eines beispielhaften photoaktiven Bauelements auf mikrostrukturiertem Substrat und in
Fig. 12 die schematische Darstellung einer Struktur eines beispielhaften photoaktiven Bauelements.

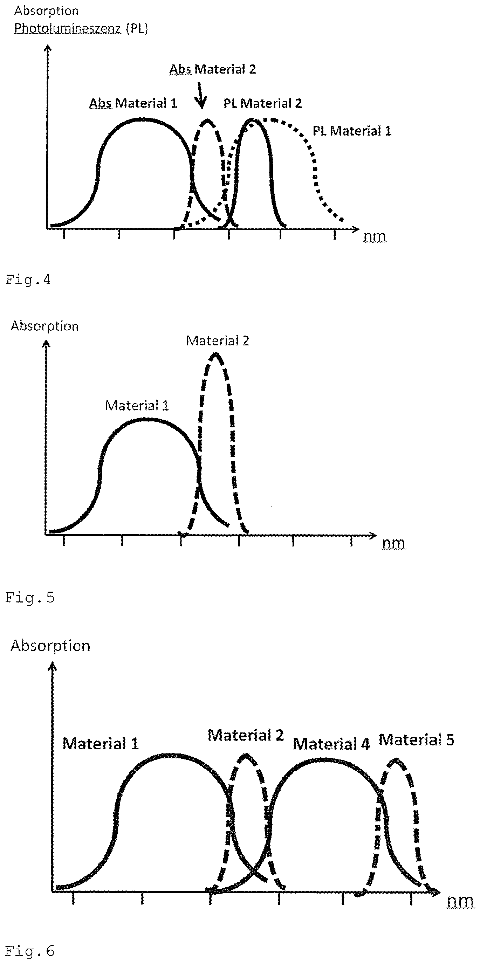

In einem ersten Ausführungsbeispiel sind zur Veranschaulichung einer erfindungsgemäßen Anordnung die Absorptions- und Photolumineszensspektren eines Materials 1 und eines Materials 2 in der Fig. 4 dargestellt.

In einem weiteren Ausführungsbeispiel verfügt das Material 2 in der Fig. 5 über eine höhere bzw. sehr hohe Absorption (Wert der optischen Dichte am Maximum) im Vergleich zu Material 1.

In einem weiteren Ausführungsbeispiel beinhaltet der Aufbau eines erfindungsgemäßen photoaktiven Bauelements eine Kombination aus einem breit-absorbierenden Material 1, welches bei kürzeren Wellenlängen im sichtbaren Bereich absorbiert und aus einem schmal-absorbierenden Material 2, welches bei längeren Wellenlängen im Infrarot-Bereich absorbiert. Die Materialien 1 bzw. 2 liegen hierbei als Einzelschichten vor.

In einer Ausgestaltung des obigen Ausführungsbeispiels liegen die Materialien 1 und 2 als Mischschichten. Es können aber beliebige Kombinationen vorhanden sein.

In einem weiteren Ausführungsbeispiel sind beide Materialien 1 und 2 Donatoren.

In einem weiteren Ausführungsbeispiel sind die beiden Materialien 1 und 2 Akzeptoren.

In einem weiteren Ausführungsbeispiel ist die Absorptionsbreite von Material 2 20nm bis 150 nm schmaler als die Absorptionsbreite von Material1, besonders bevorzugt 50nm bis 100nm.

In einem weiteren Ausführungsbeispiel besteht das Absorbersystem aus drei Materialien, wobei die Materialien 1 und 2 Akzeptoren sind und das Material 3 ein Donator ist.

In einem weiteren Ausführungsbeispiel besteht das Absorbersystem aus drei Materialien, wobei die Materialien 1 und 2 Donatoren sind und das Material 3 ein Akzeptor ist.

In einem weiteren Ausführungsbeispiel weist das Absorbersystem des erfindungsgemäßen photoaktiven Bauelements in der Realisierung als Einfachzelle eine der folgenden Aufbauten auf, worin ES=Einzelschicht und MS=Mischschicht bedeutet:
ES Material 1 / ES Material 2 / ES Material 3
ES Material 2 / ES Material 1 / ES Material 3
MS Material 1 / ES Material 2
MS Material 1 / ES Material 2 / ES Material 3
ES Material 3 / MS Material 1 / ES Material 2
MS Material 2 / ES Material 1
MS Material 2 / ES Material 1 / ES Material 3
ES Material 3 / MS Material 2 / ES Material 1
MS Material 1 / MS Material 2
MS Material 1 / MS Material 2 / ES Material 3
MS Material 2 / MS Material 1 / ES Material 3
Dreiermischschicht aus Material 1, 2 und 3

In einem weiteren Ausführungsbeispiel enthält die erste Teilzelle eine Kombination aus einem breit-absorbierenden Material (Material 1) und aus einem schmal-absorbierenden Material (Material 2), welches bei längeren Wellenlängen absorbiert als Material 1
und
die zweite Teilzelle enthält eine Kombination aus einem breit-absorbierenden Material (Material 4) und aus einem schmal-absorbierenden Material (Material 5), welches bei längeren Wellenlängen absorbiert als Material 4.

In einem weiteren Ausführungsbeispiel in der Fig. 6 absorbieren Material 1 und 2 im sichtbaren Wellenlängenbereich (VIS) und Material 4 und 5 im infraroten Bereich (IR).

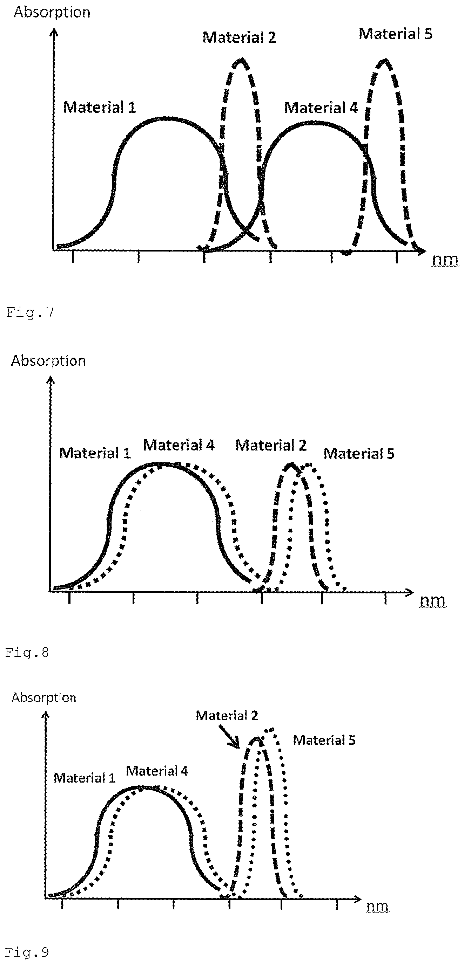

In einem weiteren Ausführungsbeispiel in der Fig. 7 besitzen die Materialien 4 und 5 eine höhere Absorption als die Materialien 1 und 2.

In einem weiteren Ausführungsbeispiel in der Fig. 8 absorbieren Material 1 und 4 im sichtbaren Wellenlängenbereich (VIS) und Material 2 und 5 im infraroten Bereich (IR), wobei die Absorptionsspektren der Materialien 1 und 4 sowie 2 und 5 überlappend verteilt sind.

In einem weiteren Ausführungsbeispiel in der Fig. 9 absorbieren Material 1 und 4 im sichtbaren Wellenlängenbereich (VIS) und Material 2 und 5 im infraroten Bereich (IR), wobei die Absorptionsspektren der Materialien 1 und 4 sowie 2 und 5 überlappend verteilt sind und die Materialien 4 und 5 eine höhere Absorption als die Materialien 1 und 2 besitzen.

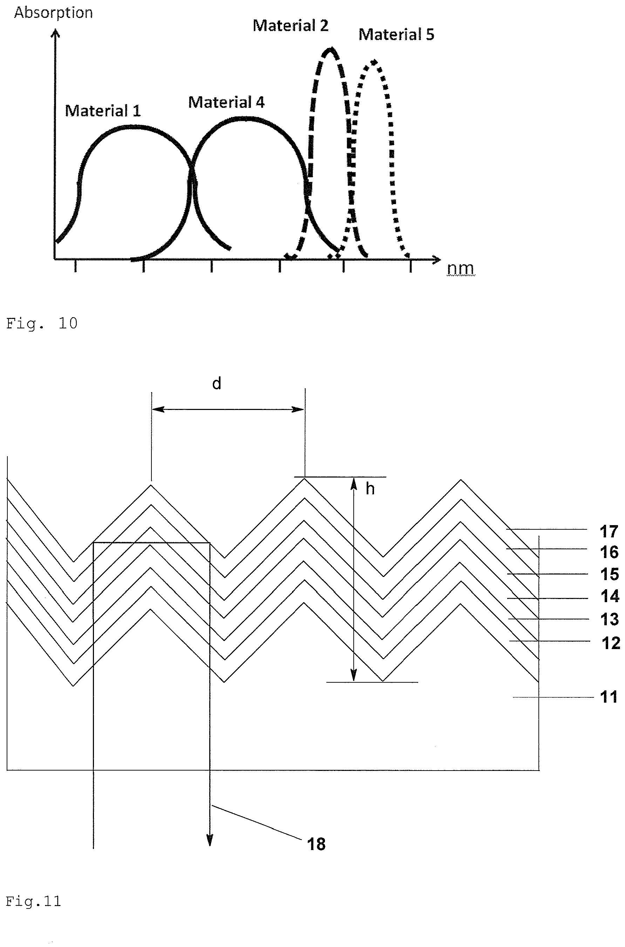

In einem weiteren Ausführungsbeispiel in der Fig. 10 absorbieren Material 1 und 4 im sichtbaren Wellenlängenbereich (VIS) und Material 2 und 5 im infraroten Bereich (IR), wobei die Materialien 2 und 5 eine höhere Absorption als die Materialien 1 und 4 besitzen und die Materialien 1 und 4 sowie 2 und 5 eine geringfügige Überlappung der Absorptionsbereiche zeigen.

In einem weiteren Ausführungsbeispiel sind in einer erfindungsgemäßen Tandemzelle beide Materialien 1 und 2 bzw. 4 und 5 jeweils Donatoren.

In einem weiteren Ausführungsbeispiel sind in einer erfindungsgemäßen Tandemzelle beide Materialien 1 und 2 bzw. 4 und 5 jeweils Akzeptoren.

In einem weiteren Ausführungsbeispiel ist das erfindungsgemäße organische Bauelement als Tandemzelle ausgeführt, wobei die jeweiligen Teilzellen ein Absorbersystem 1 für die erste Teilzelle und ein Absorbersystem 2 für die zweite Teilzelle aufweisen. Das Absorbersystem 1 der Teilzelle 1 weist dabei einen der folgenden Aufbauten auf (ES=Einzelschicht; MS=Mischschicht) :
ES Material 1 / ES Material 2 / ES Material 3
ES Material 2 / ES Material 1 / ES Material 3
MS Material 1 / ES Material 2
MS Material 1 / ES Material 2 / ES Material 3
ES Material 3 / MS Material 1 / ES Material 2
MS Material 2 / ES Material 1
MS Material 2 / ES Material 1 / ES Material 3
ES Material 3 / MS Material 2 / ES Material 1
MS Material 1 / MS Material 2
MS Material 1 / MS Material 2 / ES Material 3
MS Material 2 / MS Material 1 / ES Material 3
Dreiermischschicht aus Material 1, 2 und 3

Das Absorbersystem 2 der Teilzelle 2 weist einen der folgenden Aufbauten auf(ES=Einzelschicht; MS=Mischschicht):
ES Material 4 / ES Material 5 / ES Material 6
ES Material 5 / ES Material 4 / ES Material 6
MS Material 4 / ES Material 5
MS Material 4 / ES Material 5 / ES Material 6
ES Material 6 / MS Material 4 / ES Material 5
MS Material 5 / ES Material 4
MS Material 5 / ES Material 4 / ES Material 6
ES Material 6 / MS Material 5 / ES Material 4
MS Material 4 / MS Material 5
MS Material 4 / MS Material 5 / ES Material 6
MS Material 5 / MS Material 4 / ES Material 6
Dreiermischschicht aus Material 4, 5 und 6

In einem weiteren Ausführungsbeispiel sind die Materialien 4 und 5 Akzeptoren und das Material 6 ist ein Donator.

In einem weiteren Ausführungsbeispiel sind die Materialien 4 und 5 Donatoren und das Material 6 ist ein Akzeptor.

In einem weiteren Ausführungsbeispiel sind die Materialien 3 und 6 identisch.

In einem weiteren Ausführungsbeispiel sind eine oder mehrere der Materialien 1,2,4 und 5 identisch.

In einem weiteren Ausführungsbeispiel enthält mindestens eine der photoaktiven Mischschichten in einer der Teilzellen als Akzeptor das Material Fulleren C₆₀ und als Donator das Material 4P-TPD.

In einem weiteren Ausführungsbeispiel der Erfindung wird in Fig. 11 eine Lichtfalle zur Verlängerung des optischen Wegs des einfallenden Lichtes im aktiven System verwendet.

Dabei wird die Lichtfalle dadurch realisiert, dass das Bauelement auf einem periodisch mikrostrukturierten Substrat aufgebaut wird und die homogene Funktion des Bauelementes, dessen kurzschlussfreie Kontaktierung und eine homogene Verteilung des elektrischen Feldes über die gesamte Fläche durch die Verwendung einer dotierten wide-gap-Schicht gewährleistet wird. Besonders vorteilhaft ist dabei, dass das Licht die Absorberschicht mindestens zweimal durchläuft, was zu einer erhöhten Lichtabsorption und dadurch zu einem verbesserten Wirkungsgrad der Solarzelle führen kann. Dies lässt sich beispielsweise wie in Fig. 11 dadurch erreichen, dass das Substrat pyramidenartige Strukturen auf der Oberfläche aufweist mit Höhen (h) und Breiten (d) jeweils im Bereich von einem bis zu mehreren hundert Mikrometern. Höhe und Breite können gleich oder unterschiedlich gewählt werden. Ebenfalls können die Pyramiden symmetrisch oder asymmetrisch aufgebaut sein. Die Breite der pyramidenartigen Strukturen liegt hierbei zwischen 1µm und 200pm. Die Höhe der pyramidenartigen Strukturen kann zwischen 1µm und 1mm liegen.
1.) Bezeichnung Fig. 11:
   1µm < d < 200pm, 1µm < h < 1mm
   11: Substrat
   12: Elektrode; z.B. ITO oder Metall (10 - 200nm)
   13: HTL oder ETL-Schichtsystem (10 - 200nm)
   14: Absorbermischschicht 1 (10 - 200nm)
   15: Absorbermischschicht 2 (10 - 200nm)
   16: HTL oder ETL-Schichtsystem (10 - 200nm)
   17: Elektrode; z.B. ITO oder Metall (10 - 200nm)
   18: Weg des einfallenden Lichts

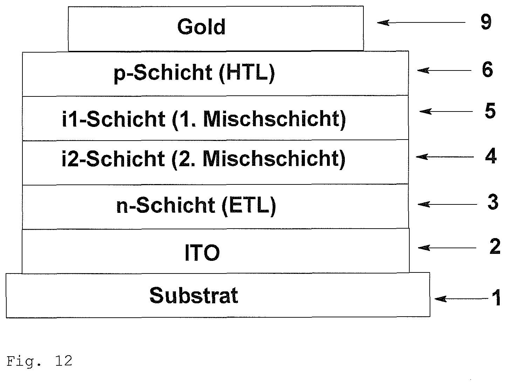

In einem weiteren Ausführungsbeispiel weist das erfindungsgemäße photoaktive Bauelement in Fig. 12 folgende Schichtreihenfolge auf:
1.) Glas-Substrat **1,**
2.) ITO Grundkontakt **2,**
3.) Elektronentransportschicht (ETL) **3,**
4.) Absorbermischschicht 1 (10 - 200nm) **4**
5.) Absorbermischschicht 2 (10 - 200nm) **5**
6.) Löchertransportschicht (HTL) **6,**
7.) Deckkontakt (z.B. Gold) **9.**

### Bezugszeichenliste

- 1: Substrat
- 2: Grundkontakt (Elektrode)
- 3: Transportschichtsystem (ETL bzw. HTL)
- 4: photoaktives Schichtsystem 1
- 5: photoaktives Schichtsystem 2
- 6: Transportschichtsystem (HTL bzw. ETL)
- 9: Deckkontakt (Elektrode)

- 11: Substrat
- 12: Elektrode
- 13: HTL oder ETL-Schichtsystem
- 14: Absorbermischschicht 1
- 15: Absorbermischschicht 2
- 16: HTL oder ETL-Schichtsystem
- 17: Elektrode
- 18: Weg des einfallenden Lichts

## Patentansprüche

1. Photoaktives Bauelement mit organischen Schichten bestehend aus einer Einfach-, Tandem- oder Mehrfachzelle mit zwei Elektroden (2,9) und zwischen den Elektroden (2,9) ein photoaktives Akzeptor-Donator-Schichtsystem (4), welches zumindest drei Absorbermaterialien 1, 2, 3 umfasst, wobei zumindest zwei Absorbermaterialien des photoaktiven Akzeptor-Donator-Schichtsystems (4) zumindest teilweise in einer Mischschicht vorhanden sind, wobei zumindest Absorbermaterial 1 und Absorbermaterial 2 Donatoren sind und Absorbermaterial 3 ein Akzeptor ist, oder zumindest Absorbermaterial 1 und Absorbermaterial 2 ein Akzeptor sind und Absorbermaterial 3 ein Donator ist, **dadurch gekennzeichnet, dass**
(i) das Absorbermaterial 2 bei einer größeren Wellenlänge absorbiert als das Absorbermaterial 1, und
(ii) das Absorbermaterial 2 einen geringeren Stokes-Shift hat und/oder eine geringere Absorptionsbreite im Film als das Absorbermaterial 1 aufweist, und
(iii) das Absorbermaterial 2 eine höhere Absorption, Wert der optischen Dichte am Maximum, im Vergleich zum Absorbermaterial 1 aufweist.

2. Photoaktives Bauelement nach Anspruch 1, **dadurch gekennzeichnet, dass** sich der Absorptionsbereich zumindest eines der Absorbermaterialien in den Infrarot-Bereich im Wellenlängenbereich von >700nm bis 1500nm erstreckt.

3. Photoaktives Bauelement nach Anspruch 1 oder 2, **dadurch gekennzeichnet, dass** die Absorptionsbreite des Absorbermaterials 2 20 bis 250 nm schmaler als die Absorptionsbreite des Absorbermaterials 1 ist.

4. Photoaktives Bauelement nach einem der Ansprüche 1 bis 3, **dadurch gekennzeichnet, dass** zwischen den Elektroden und den/dem photoaktiven Schichtsystem/en und/oder zwischen den photoaktiven Schichtsystemen verschiedener Zellen eine oder mehrere undotierte, teilweise dotierte oder ganz dotierte Schichten (3,6), als Transportschichten angeordnet sind.

5. Photoaktives Bauelement nach einem der Ansprüche 1 bis 4, **dadurch gekennzeichnet, dass** eine oder mehrere der Transportschichten (3,6) wide-gap Schichten mit einem Maximum der Absorption bei < 450nm sind.

6. Photoaktives Bauelement nach einem der Ansprüche 1 bis 5, **dadurch gekennzeichnet, dass** die Schichten des Schichtsystems des Bauelements als eine den optischen Weg des einfallenden Lichts verlängernde Lichtfalle ausgebildet sind.

7. Photoaktives Bauelement nach einem der Ansprüche 1 bis 6, **dadurch gekennzeichnet, dass** mindestens eines der Absorbermaterialien des photoaktiven Akzeptor-Donator-Schichtsystems (4) ein Material aus der Klasse der Fullerene bzw. Fullerenderivate, Phthalocyanine, Perylenderivate, TPD-Derivate oder Oligothiophen-Derivate ist.

8. Photoaktives Bauelement nach einem der Ansprüche 1 bis 7, **dadurch gekennzeichnet, dass** sich die HOMO-Lagen des einen der zumindest zwei Absorbermaterialien, welche als Donatoren oder Akzeptoren im photoaktiven Akzeptor-Donator-Schichtsystem (4) ausgebildet sind, um maximal 0,2eV vom anderen Absorbermaterial unterscheiden, bevorzugt um maximal 0,1eV.

9. Photoaktives Bauelement nach einem der Ansprüche 1 bis 8, **dadurch gekennzeichnet, dass** das Bauelement aus einer Kombination aus nip, ni, ip, pnip, pni, pip, nipn, nin, ipn, pnipn, pnin oder pipn-Strukturen besteht, bei der zwei oder mehrere unabhängige Kombinationen, welche mindestens eine i-Schicht enthalten, übereinander gestapelt sind, wobei p eine p-dotierte Schicht, n eine n-dotierte Schicht und i eine im elektrischen Sinne undotierte oder im Vergleich zu dotierten Schichten nur gering dotierte Schicht bedeutet.

10. Photoaktives Bauelement nach einem der Ansprüche 1 bis 9, **dadurch gekennzeichnet, dass** das Bauelement zumindest in einem gewissen Lichtwellenlängenbereich semitransparent ist.

11. Verwendung eines photoaktiven Bauelements gemäß einem der Ansprüche 1 bis 10 auf ebenen, gekrümmten oder flexiblen Trägerflächen.

## Claims

1. Photoactive component comprising organic layers consisting of a single, tandem or multiple cell having two electrodes (2,9) and between the electrodes (2,9) a photoactive acceptor-donor layer system (4) comprising at least three absorber materials 1, 2, 3, wherein at least two absorber materials of the photoactive acceptor-donor layer system (4) are present at least partly in a mixed layer, wherein at least absorber material 1 and absorber material 2 are donors and absorber material 3 is an acceptor, or at least absorber material 1 and absorber material 2 are an acceptor and absorber material 3 is a donor, **characterized in that**
(i) absorber material 2 absorbs at a greater wavelength than absorber material 1, and
(ii) absorber material 2 has a smaller Stokes shift and/or a smaller absorption width in the film than absorber material 1, and
(iii) absorber material 2 has a higher absorption, value of the optical density at the maximum, in comparison with absorber material 1.

2. Photoactive component according to Claim 1, **characterized in that** the absorption range of at least one of the absorber materials extends into the infrared range in the wavelength range of > 700 nm to 1500 nm.

3. Photoactive component according to Claim 1 or 2, **characterized in that** the absorption width of absorber material 2 is 20 to 250 nm narrower than the absorption width of absorber material 1.

4. Photoactive component according to any of Claims 1 to 3, **characterized in that** one or more undoped, partly doped or fully doped layers (3,6), as transport layers, are arranged between the electrodes and the photoactive layer system(s) and/or between the photoactive layer systems of different cells.

5. Photoactive component according to any of Claims 1 to 4, **characterized in that** one or more of the transport layers (3,6) are wide-gap layers having a maximum of the absorption at < 450 nm.

6. Photoactive component according to any of Claims 1 to 5, **characterized in that** the layers of the layer system of the component are embodied as a light trap which lengthens the optical path of the incident light.

7. Photoactive component according to any of Claims 1 to 6, **characterized in that** at least one of the absorber materials of the photoactive acceptor-donor layer system (4) is a material from the class of the fullerenes or fullerene derivatives, phthalocyanines, perylene derivatives, TPD derivatives or oligothiophene derivatives.

8. Photoactive component according to any of Claims 1 to 7, **characterized in that** the HOMO levels of one of the at least two absorber materials which are embodied as donors or acceptors in the photoactive acceptor-donor layer system (4) differ from the other absorber material by a maximum of 0.2 eV, preferably by a maximum of 0.1 eV.

9. Photoactive component according to any of Claims 1 to 8, **characterized in that** the component consists of a combination of nip, ni, ip, pnip, pni, pip, nipn, nin, ipn, pnipn, pnin or pipn structures, in which two or more independent combinations containing at least one i-layer are stacked one above another, wherein p denotes a p-doped layer, n denotes an n-doped layer and i denotes a layer which, in the electrical sense, is undoped or only lightly doped in comparison with doped layers.

10. Photoactive component according to any of Claims 1 to 9, **characterized in that** the component is semitransparent at least in a certain light wavelength range.

11. Use of a photoactive component according to any of Claims 1 to 10 on planar, curved or flexible carrier surfaces.

## Revendications

1. Composant photo-actif doté de couches organiques constitué d'une cellule simple, en tandem ou multiple avec deux électrodes (2, 9) et, entre les électrodes (2, 9), d'un système de couches accepteur-donneur photo-actif (4), qui comprend au moins trois matériaux absorbants 1, 2, 3, dans lequel au moins deux matériaux absorbants du système de couches accepteur-donneur photo-actif (4) sont au moins partiellement présents dans une couche mixte, dans lequel au moins le matériau absorbant 1 et le matériau absorbant 2 sont des donneurs et le matériau absorbant 3 est un accepteur, ou au moins le matériau absorbant 1 et le matériau absorbant 2 sont un accepteur et le matériau absorbant 3 est un donneur,
**caractérisé en ce que**
(i) le matériau absorbant 2 absorbe à une longueur d'onde plus élevée que le matériau absorbant 1, et
(ii) le matériau absorbant 2 présente un décalage de Stokes inférieur et/ou une largeur d'absorption dans le film inférieure à celle du matériau absorbant 1, et
(iii) le matériau absorbant 2 présente une absorption, c'est-à-dire une valeur de densité optique au maximum, qui est supérieure par comparaison au matériau absorbant 1.

2. Composant photo-actif selon la revendication 1, **caractérisé en ce que** la plage d'absorption d'au moins l'un des matériaux absorbants s'étend dans le domaine infrarouge, dans la plage de longueurs d'onde de >700 nm à 1500 nm.

3. Composant photo-actif selon la revendication 1 ou 2, **caractérisé en ce que** la largeur d'absorption du matériau absorbant 2 est plus étroite de 20 à 250 nm que la largeur d'absorption du matériau absorbant 1.

4. Composant photo-actif selon l'une des revendications 1 à 3, **caractérisé en ce qu'**une ou plusieurs couches non dopées, partiellement dopées ou entièrement dopées (3, 6) sont disposées en tant que couches de transport entre les électrodes et le(s) système(s) de couches photo-actif(s) et/ou entre les systèmes de couches photo-actifs de différentes cellules.

5. Composant photo-actif selon l'une des revendications 1 à 4, **caractérisé en ce qu'**une ou plusieurs des couches de transport (3,6) sont des couches à large bande interdite ayant une absorption maximale de <450 nm.

6. Composant photo-actif selon l'une des revendications 1 à 5, **caractérisé en ce que** les couches du système de couches du composant sont réalisées sous la forme d'un piège à lumière prolongeant le chemin optique de la lumière incidente.

7. Composant photo-actif selon l'une des revendications 1 à 6, **caractérisé en ce qu'**au moins l'un des matériaux absorbants du système de couches accepteur-donneur photo-actif (4) est un matériau de la classe des fullerènes ou des dérivés de fullerène, des phtalocyanines, des dérivés de pérylène, des dérivés de TPD ou des dérivés d'oligothiophène.

8. Composant photo-actif selon l'une des revendications 1 à 7, **caractérisé en ce que** les couches HOMO de l'un desdits au moins deux matériaux absorbants, qui sont réalisés sous la forme de donneurs ou d'accepteurs dans le système de couches accepteur-donneur photo-actif (4), diffèrent de celles de l'autre matériau absorbant d'au plus 0,2eV, de préférence d'au plus 0,1eV.

9. Composant photo-actif selon l'une des revendications 1 à 8, **caractérisé en ce que** le composant consiste en une combinaison de structures nip, ni, ip, pnip, pni, pip, nipn, nin, ipn, pnipn, pnin ou pipn, dans lesquelles deux ou plusieurs combinaisons indépendantes contenant au moins une couche i sont empilées les unes sur les autres, où p est une couche dopée p, n est une couche dopée n et i est une couche non dopée au sens électrique ou seulement légèrement dopée par rapport aux couches dopées.

10. Composant photo-actif selon l'une des revendications 1 à 9, **caractérisé en ce que** le composant est semi-transparent au moins dans une certaine plage de longueurs d'onde de la lumière.

11. Utilisation d'un composant photo-actif selon l'une des revendications 1 à 10 sur des surfaces de support planes, courbes ou flexibles.
